# EUROPEAN PATENT APPLICATION

(11) **EP 4 283 661 A1**
(43) Date of publication of application: **29.11.2023**
(21) Application number: 21921093.7
(22) Date of filing: 25.01.2021
(51) Int. Cl.: H01L 21/31

(54) **SUBSTRATE TREATMENT APPARATUS, PRODUCTION METHOD FOR SEMICONDUCTOR DEVICE, PRESSURE CONTROL DEVICE, AND SUBSTRATE TREATMENT PROGRAM**

(71) Applicant: Kokusai Electric Corporation, Tokyo 101-0045 (JP)
(72) Inventor: YACHI, Masamichi, Toyama-shi, Toyama 939-2393 (JP); NAKADA, Takayuki, Toyama-shi, Toyama 939-2393 (JP)
(74) Representative: Bardehle Pagenberg Partnerschaft mbB Patentanwälte Rechtsanwälte
(86) International application number: PCT/JP2021/002494
(87) International publication number: WO 2022/157986

(57) **Abstract**

A substrate processing apparatus 100 includes a process container 20 in which a substrate is processed, an exhaust path 50 that is connected between the process container 20 and an exhaust device 60 and configured to branch into a first exhaust line and a second exhaust line between the process container 20 and the exhaust device 60, a first valve 58A that is installed in the first exhaust line 52 and configured to be capable of continuously adjusting an opening degree of the first valve, a second valve 58B that is installed in the second exhaust line 54 and configured to be capable of continuously adjusting an opening degree of the second valve, and a pressure control device configured to be capable of selecting one valve among the first valve 58A and the second valve 58B according to a pressure setting value in the process container, which is set at each time for processing the substrate, such that a pressure detection value detected by a pressure detector approaches the pressure setting value; setting an opening degree of an other valve, which is not selected among the first valve and the second valve, to a constant state, and adjusting an opening degree of the selected one valve while maintaining the opening degree of the selected one valve at a value greater than zero.

## Description

### TECHNICAL FIELD

The present disclosure relates to a substrate processing apparatus, a method of manufacturing a semiconductor device, a pressure control device, and a substrate processing program.

### BACKGROUND

In a process of manufacturing a semiconductor device, a vertical substrate processing apparatus may be often used as an apparatus for processing a semiconductor substrate (hereinafter simply referred to as a substrate) which is an object to be processed, including a semiconductor. Japanese laid-open publication No. 7-45492 and WO2020/194434 disclose a technique in which a plurality of valves having different conductances are arranged in parallel in an exhaust system connected to a process container such as a reaction chamber in which a process is performed, in a substrate processing apparatus.

In Japanese laid-open publication No. 7-45492, when an opening degree of a small-diameter valve is nearly fully opened, an operation of opening a larger-diameter valve than the small-diameter valve is sequentially performed. By sequentially opening a plurality of valves with different conductances, the variable range of conductance is expanded, so that a control range of pressure in the reaction chamber is expanded.

However, in the case of the technique disclosed in Japanese laid-open publication No. 7-45492, switching between the plurality of valves may occur unexpectedly during pressure control, and as a result, there is a concern that the pressure control may be interrupted.

### SUMMARY

The present disclosure provides some embodiments of a technique capable of preventing interruption of pressure control due to switching between a plurality of valves during pressure control.

According to one embodiment of the present disclosure, there is provided a technique including: a process container in which a substrate is processed; an exhaust path that is connected between the process container and an exhaust device and configured to branch into a first exhaust line and a second exhaust line between the process container and the exhaust device; a first valve that is installed in the first exhaust line and configured to be capable of continuously adjusting an opening degree of the first valve; a second valve that is installed in the second exhaust line and configured to be capable of continuously adjusting an opening degree of the second valve; a pressure detector configured to detect a pressure in the process container; and a pressure control device configured to be capable of: selecting one valve among the first valve and the second valve according to a pressure setting value in the process container, which is set at each time for processing the substrate, such that a pressure detection value detected by the pressure detector approaches the pressure setting value; setting an opening degree of an other valve, which is not selected among the first valve and the second valve, to a constant state; and adjusting an opening degree of the selected one valve while maintaining the opening degree of the selected one valve at a value greater than zero.

According to the present disclosure, it is possible to prevent interruption of pressure control due to switching between a plurality of valves during pressure control.

### BRIEF DESCRIPTION OF DRAWINGS

FIG. 1 is a schematic view illustrating an overall configuration of a substrate processing apparatus according to some embodiments of the present disclosure.
FIG. 2 is a schematic view illustrating a configuration of an exhaust path of a substrate processing apparatus according to the present embodiment
FIG. 3 is a block diagram illustrating a configuration of a main controller of a substrate processing apparatus according to the present embodiment.
FIG. 4 is a graph illustrating criteria used when selecting a valve for pressure control in the present embodiment.
FIG. 5 is a schematic diagram for explaining an example of a film-forming operation which is a substrate processing method using a substrate processing apparatus according to the present embodiment.

### DETAILED DESCRIPTION

Embodiments of the present disclosure will now be described. In the following description of the drawings, the same or similar parts are denoted by the same or similar reference numerals. However, the drawings are schematic, and the relationship between the thickness and the planar dimensions, the ratio of the thicknesses of devices and members, etc. are different from the actual ones. Therefore, specific thicknesses and dimensions should be determined with reference to the following description. In addition, there are portions with different dimensional relationships and ratios between figures. In addition, the upward direction of the drawings may be described as upward or upper side, and the downward direction thereof may be described as downward or lower side. Moreover, a pressure described in the present embodiment means the "atmospheric pressure" unless otherwise specified.

### <Overall Configuration of Substrate Processing Apparatus>

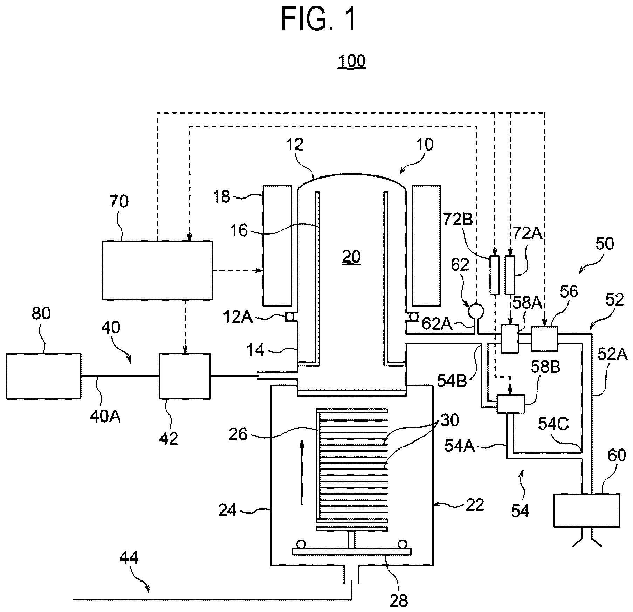

As shown in FIG. 1, a substrate processing apparatus 100 includes a reaction furnace 10 having a process container 20 for processing substrates 30, a preliminary chamber 22 having a boat 26 for transferring the substrates 30 to the process container 20, and a first gas introduction line 40 for introducing a gas. The substrate processing apparatus 100 also include an exhaust path 50 for discharging a gas from the process container 20 and a main controller 70 for controlling the operation of the substrate processing apparatus 100.

### (Reaction Furnace)

In the reaction furnace 10, as shown in FIG. 1, there is formed the process container 20 that includes a reaction tube 12 formed in a tubular shape having an axis in a vertical direction and a furnace port flange 14 connected to a lower portion of the reaction tube 12 with an airtight member 12A interposed therebetween and formed in a tubular shape having an axis in the vertical direction. A gas supply device 80 is connected to the process container 20.

Further, in the reaction furnace 10, an inner tube 16 is supported inside the reaction tube 12 to be concentric with the reaction tube 12. Further, a heater 18 is provided on an outer periphery of the reaction tube 12 to be concentric with the axis of the reaction tube 12 and spaced apart from an outer surface of the reaction tube 12. The heater 18 has a function of receiving a signal from the main controller 70 and generating a heat to heat the reaction tube 12. The reaction furnace 10 is configured by the reaction tube 12, the furnace port flange 14, the inner tube 16, the heater 18, and the process container 20. The substrates 30 are arranged inside the process container 20.

### (Preliminary Chamber)

As shown in FIG. 1, the preliminary chamber 22 includes a transfer housing 24 that airtightly communicates with a lower portion of the furnace port flange 14. The boat 26 on which the substrates 30 are placed and which transfers and inserts the substrates 30 into the process container 20 is installed inside the transfer housing 24 so as to be vertically movable. Further, a second gas introduction line 44 having the same configuration as the first gas introduction line 40 communicates with a lower portion of the transfer housing 24. A gas to be introduced into the process container 20 may be introduced from the second gas introduction line 44. A furnace port lid 28 for hermetically closing the transfer housing 24 is installed at a bottom of the transfer housing 24 and below the boat 26.

### (Gas Introduction Line)

As shown in FIG. 1, the first gas introduction line 40 includes the gas supply device 80, a gas introduction pipe 40A that communicates between the gas supply device 80 and the furnace port flange 14, and a flow rate controller 42 installed in the gas introduction pipe 40A between the gas supply device 80 and the furnace port flange 14. The gas supply device 80 supplies a gas with its flow rate controlled according to a recipe through the flow rate controller 42 into the process container 20. The flow rate controller 42 has a function of opening/closing a valve (not shown) installed therein in response to a signal from the main controller 70 to control an amount of introduced gas. Further, the second gas introduction line 44 has the same configuration as the first gas introduction line 40 except that the former communicates between the gas supply device 80 and the lower portion of the transfer housing 24, and is installed as a spare for the first gas introduction line 40.

### (Exhaust Path)

As shown in FIG. 1, the exhaust path 50 includes a first exhaust line 52 that is a main exhaust line, and a second exhaust line 54 that is a bypass exhaust line. The exhaust path 50 is connected between the process container 20 and an exhaust device 60 and branches into the first exhaust line 52 and the second exhaust line 54 between the process container and the exhaust device. That is, the first exhaust line 52 and the second exhaust line 54 are provided in parallel with each other. The process container 20 is connected to the exhaust device 60 such as a pump by the first exhaust line 52 and the second exhaust line 54. In the present disclosure, the exhaust device 60 may be included in the substrate processing apparatus 100.

The first exhaust line 52 includes at least a large-diameter pipe 52A as a first pipe for discharging a gas from the process container 20, a first valve 58A and a gate valve 56 installed in the pipe 52A, and a pressure detector 62 that is installed in the pipe 52A and detects a pressure of the process container 20.

The second exhaust line 54 includes at least a pipe 54A as a second pipe that is connected to the pipe 52A and, when a diameter of the pipe 52A is D, has a diameter of D × (0.5 to 0.9), and a second valve 58B installed in the pipe 54A.

### (First Exhaust Line)

As shown in FIG. 1, the pipe 52A, which communicates from the process container 20 to the exhaust device 60, and the first valve 58A and the gate valve 56, which are between the process container 20 and the exhaust device 60, are installed in the first exhaust line 52. The gate valve 56 is electrically connected to the main controller 70. The opening/closing operation of the gate valve 56 is performed based on a signal from the main controller 70 electrically connected to the pressure detector 62.

Further, the first valve 58A is electrically connected to a first controller 72A. In the first valve 58A, the opening/closing operation and the opening degree adjustment are performed based on a signal from the first controller 72A electrically connected to the pressure detector 62. The first exhaust line 52 is configured to exhaust a gas in the process container 20 by a suction operation of the exhaust device 60 when the first valve 58A and the gate valve 56 are opened. In this embodiment, the diameter of the pipe 52A is 200 mm (200 ϕ) as an example.

### (Second Exhaust Line)

As shown in FIG. 1, the second exhaust line 54 has a branch portion 54B that branches at a substantially right angle between the process container 20 and the gate valve 56 in the pipe 52A, the pipe 54A that communicates with a merging portion 54C merging between the gate valve 56 and the exhaust device 60, and the second valve 58B that is installed in the pipe 54A between the branch portion 54B and the merging portion 54C.

The second valve 58B is electrically connected with a second controller 72B. In the second valve 58B, the opening/closing operation and the opening degree adjustment are performed based on a signal from the second controller 72B that receives pressure information of the process container 20 from the main controller 70 electrically connected to the pressure detector 62.

The second exhaust line 54 is configured to exhaust a gas in the process container 20 by a suction operation of the exhaust device 60 when the gate valve 56 is closed. The diameter of the pipe 54A is 40 mm or more and 180 mm or less, specifically 80 mm or more and 140 mm or less, more specifically 80 mm or more and 100 mm or less (80 ϕ or more and 100 ϕ or less). In this embodiment, the diameter of the pipe 54A is 100 mm (100 ϕ) as an example.

If the pipe 54A has a smaller diameter than the first exhaust line 52, the second exhaust line 54 may be larger than 180 mm. Further, if the diameter of the pipe 54A is larger than 140 mm, there is a concern that particles may be generated during exhaust from the atmospheric pressure, which will be described later, regardless of the adjustment of the second valve 58B. On the other hand, if the pipe 54A is too small, the process will be affected due to the exhaust capacity of the exhaust line. For example, if the diameter of the pipe 54A is 40 mm or less, there is a concern that the exhaust capacity may affect the process.

### (First Valve and Second Valve)

Both the first valve 58A and the second valve 58B are, for example, APC valves. In this embodiment, the first valve 58A is configured as a butterfly valve, and the second valve 58B is configured as a poppet valve. In the present disclosure, the configurations of the first valve 58A and the second valve 58B are not limited thereto, and can be changed as appropriate.

The first valve 58A is installed in the first exhaust line 52. The degree of opening of the first valve 58A is continuously adjustable. Further, in the first exhaust line 52, the gate valve 56, which is an opening/closing valve, is installed in series with the first valve 58A. Further, the second valve 58B are installed in the second exhaust line 54. A degree of opening of the second valve 58B is continuously adjustable. Further, a flow end portion, which is an end portion of the first exhaust line 52 opposite to the process container 20, is connected to a suction side of the exhaust device 60. The exhaust device 60 may be included in the exhaust path 50.

The first valve 58A has a maximum conductance greater than the maximum conductance of the second valve 58B. The maximum conductance refers to the conductance of a fully-open valve. The first valve 58A and the second valve 58B are selected according to a pressure setting value inside the process container 20, which is set at each time for processing the substrates. That is, the pressure setting value is set as a target value at each of a plurality of times in the future. In other words, in this embodiment, the future pressure setting value changes with time.

The exhaust path 50 is configured to be controlled by the first controller 72A that controls the first valve 58A, the second controller 72B that controls the second valve 58B, and the main controller 70. The main controller, the first controller, and the second controller constitute a pressure control device of this embodiment.

### (Pressure Detector)

As shown in FIG. 1, the pressure detectors 62 are installed in communication with each other by a plurality of pipes 62A arranged on the process container 20 side from a position corresponding to the branch portion 54B of the pipe 52A. The pressure detector 62 is electrically connected to the main controller 70 and has a function of transmitting the pressure information of the process container 20. The pressure detected by the pressure detector 62 is set as an internal pressure of the process container 20.

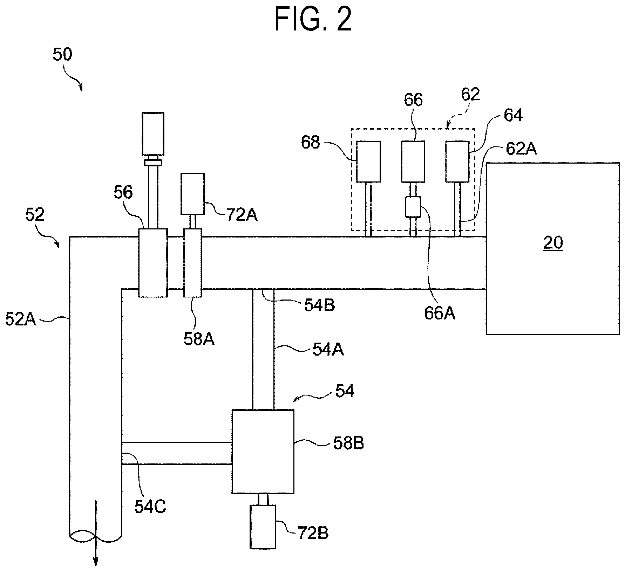

As shown in FIG. 2, the pressure detector 62 is composed of an atmospheric pressure sensor 64, a first vacuum sensor 68, and a second vacuum sensor 66. The first vacuum sensor 68, the second vacuum sensor 66, and the atmospheric pressure sensor 64 are installed in each pipe 62A connected to the pipe 52A in this order from the side closer to the branch portion 54B, which is the side opposite to the process container 20, toward the side farther from the branch portion 54B which is the process container 20 side. The atmospheric pressure sensor 64, the first vacuum sensor 68, and the second vacuum sensor 66 are examples of pressure sensors.

### (Atmospheric Pressure Sensor)

As shown in FIG. 2, the atmospheric pressure sensor 64 is installed in the pipe 62A connected to the pipe 52A closest to the process container 20 and has a function of detecting a pressure in a region close to the atmospheric pressure.

### (First Vacuum Sensor)

As shown in FIG. 2, the first vacuum sensor 68 is installed in the pipe 62A and functions as a wide-range pressure sensor that detects a pressure in a region close to the atmospheric pressure to a pressure in a predetermined vacuum region (10⁻¹ to 10⁵ Pa). Here, the first vacuum sensor 68 is configured to detect a pressure in a range from the atmospheric pressure to approximately 1.333×10³ Pa (approximately 10 torr).

### (Second Vacuum Sensor)

As shown in FIG. 2, the second vacuum sensor 66 is installed in the pipe 62A, and a valve 66A, which opens when the pressure is reduced to a predetermined pressure, is installed in the second vacuum sensor 66. The second vacuum sensor 66 functions as a pressure sensor that detects a pressure in a high-vacuum region. In this embodiment, the second vacuum sensor 66 is configured to detect the pressure with the valve 66A opened at approximately 1.333×10³ Pa (approximately 10 torr).

### (Main Controller)

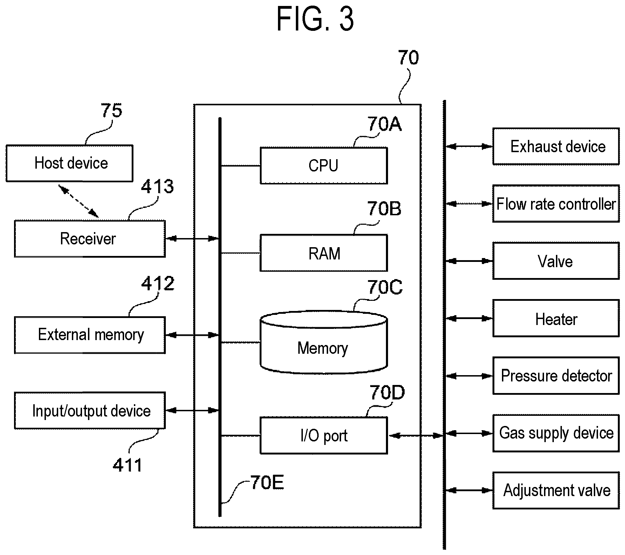

As shown in FIG. 3, the substrate processing apparatus 100 has the main controller 70 that controls the operation of each part. The main controller 70, which is control means, is configured as a computer including a CPU (Central Processing Unit) 70A, a RAM (Random Access Memory) 70B, a memory 70C, and an I/O port 70D. The main controller 70 can execute a process recipe, which is one of substrate processing programs, to control a substrate processing process which is one process of manufacturing a semiconductor device.

The RAM 70B, the memory 70C, and the I/O port 70D are configured to exchange data with the CPU 70A via an internal bus 70E. An input/output device 411 configured as, for example, a touch panel, and an external memory 412 are configured to be connectable to the main controller 70. Further, a receiver 413 connected to a host device 75 via a network is installed. The receiver 413 can receive information about other devices from the host device 75.

The memory 70C is composed of, for example, a flash memory, a HDD (Hard Disk Drive), or the like. A control program for controlling the operations of the substrate processing apparatus 100, a process recipe, a correction recipe, etc. in which sequences and conditions of substrate processing to be described later are written, are readably stored in the memory 70C. The process recipe and the correction recipe function as programs for causing the main controller 70 to execute each sequence in a substrate processing process and a characteristic checking process performed in a substrate processing mode, to obtain an expected result.

When the term "program" is used herein, it may indicate a case of including the process recipe and the correction recipe alone, a case of including the control program alone, or a case of including all the process recipe, the correction recipe, and the control program. The RAM 70B is configured as a memory area (work area) in which a program or data read by the CPU 70A is temporarily stored.

The I/O port 70D is connected to an exhaust device, a flow rate controller, a valve, a heater, a pressure detection part, a gas supply device, an adjustment valve (APC valve), and the like.

The main controller 70 performs the start and stop of the vacuum exhaust device, the opening/closing operation of valves, the temperature adjustment of the heater, the operation control of the pressure detector, the flow rate adjustment of APC valves, and the like which are installed in the substrate processing apparatus 100. Specifically, in this embodiment, the main controller adjusts the opening degree of the first valve 58A and the opening degree of the second valve 58B while maintaining the opening degrees at values greater than zero, which is not fully closed. The main controller is configured to allow a pressure detection value detected by the pressure sensor to approach the future pressure setting value by adjusting the opening degrees of the valves.

Hereinafter, when there is a description that a valve is fully closed, fully blocked, or fully shutoff, this description has the same meaning as that the opening degree of the valve is zero or 0 % with respect to the opening degree of the valve in the fully open state. Further, when there is a description that a valve is opened, this description has the same meaning as that the opening degree of the valve is in a fully open state, that is, the opening degree is 100 %.

The main controller 70 is not limited to being configured as a dedicated computer, and may be configured as a general-purpose computer. For example, the external memory (for example, a semiconductor memory such as a USB memory or a memory card) 412 storing the above program is prepared. Then, the main controller 70 according to the present embodiment can be configured by installing a program in the general-purpose computer by using the prepared external memory 412.

Further, a means for supplying the program to the computer is not limited to a case of supplying the program via the external memory 412. For example, the program may be provided to the computer using communication means such as the Internet or a dedicated line, instead of using the external memory 412. The memory 70C or the external memory 412 is configured as a computer-readable recording medium. Hereinafter, the memory 70C and the external memory 412 may be generally and simply referred to as a "recording medium." When the term "recording medium" is used herein, it may indicate a case of including the memory 70C alone, a case of including the external memory 412 alone, or a case of including both the memory 70C and the external memory 412.

### (First Controller and Second Controller)

Both the first controller 72A and the second controller 72B are, for example, APC controllers. The first controller 72A is installed in the pipe 52A of the first exhaust line 52 so as to be connected to the first valve.

The first controller 72A is configured to automatically adjust the conductance of the first valve 58A based on the pressure detection value and the pressure setting value. The second controller 72B is configured to automatically adjust the conductance of the second valve based on the pressure detection value and the pressure setting value. The second controller 72B is installed in the pipe 54A of the second exhaust line 54 so as to be connected to the second valve.

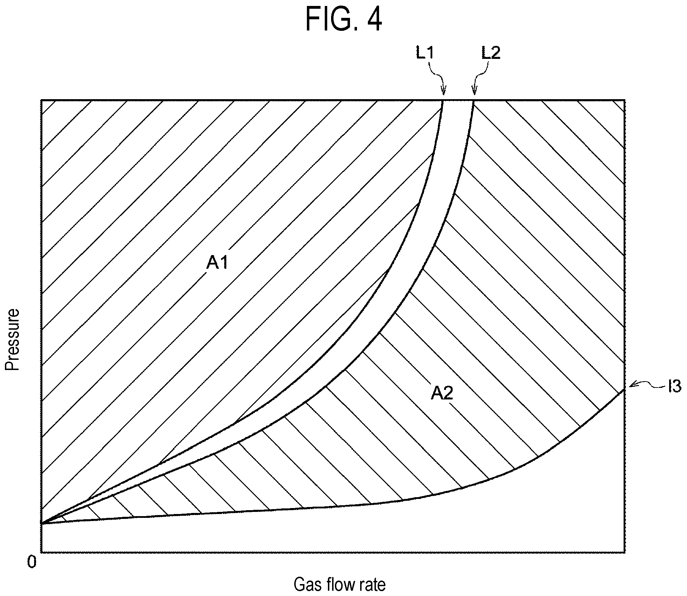

The pressure control device selects one among the first valve 58A and the second valve 58B according to a combination condition of a future gas flow rate by the gas supply device 80 and the future pressure setting value. Specifically, as shown in FIG. 4, monotonically increasing curves created based on the gas flow rate supplied to the process container 20 and the internal pressure of the process container 20 are used.

FIG. 4 illustrates a first monotonically increasing curve L1, a second monotonically increasing curve L2, and a third monotonically increasing curve L3 which are defined by a coordinate system in which a horizontal axis is a gas flow rate (volumetric flow rate) and a vertical axis is an internal pressure of the process chamber. The first monotonically increasing curve L1, the second monotonically increasing curve L2, and the third monotonically increasing curve L3 are determined based on exhaust characteristics of the substrate processing apparatus 100.

The first monotonically increasing curve L1 is a trajectory of data points obtained from experimental results of detecting a pressure while changing a gas flow rate when the first valve 58A is fixed in a "fully closed" state and the second valve 58B is fixed in a "fully open" state in the substrate processing apparatus 100.

The second monotonically increasing curve L2 is a trajectory of data points obtained from experimental results of detecting a pressure while changing a gas flow rate when the opening degree of the first valve 58A is not zero, that is fully closed, but is the minimum value slightly larger than zero and the second valve 58B is in the "fully open" state in the substrate processing apparatus 100.

The third monotonically increasing curve L3 is a trajectory of data points obtained from experimental results of detecting a pressure while changing a gas flow rate when the first valve 58A is substantially in the "fully open" state and the second valve 58B is in the "fully open" state in the substrate processing apparatus 100.

In FIG. 4, a high-pressure control region A1 is formed between the vertical axis and the first monotonically increasing curve L1. In the high-pressure control region A1, it is possible to change the gas flow rate to achieve a target pressure setting value by adjusting the opening degree of the second valve 58B between the minimum value of zero or more, which is not fully closed, and the fully opening degree in the state where the first valve 58A is "fully closed."

In FIG. 4, a low-pressure control region A2 is formed between the second monotonically increasing curve L2 and the third monotonically increasing curve L3. In the low-pressure control region A2, it is possible to change the gas flow rate to achieve a target pressure setting value by adjusting the opening degree of the first valve 58A between the minimum value of zero or more, which is not fully closed, and the fully opening degree in the state where the second valve 58B is "fully open".

In this embodiment, the monotonically increasing curves are used to create a recipe for pressure control, which is given to the main controller 70 of the pressure control device. Each process that constitutes the substrate processing is described in the recipe.

In this embodiment, the main controller 70 is configured to be able to adjust an opening degree of a selected valve while maintaining an opening degree at a value greater than zero through a controller corresponding to the selected valve among the first controller 72A and the second controller 72B, based on the given recipe. The internal pressure of the process container 20 is controlled by adjusting the opening degree of the selected valve.

Further, in this embodiment, the main controller 70 forces a controller corresponding to a non-selected valve among the first controller 72A and the second controller 72B to fully close the non-selected valve, based on the recipe. In this embodiment, "fully closing a valve" means including at least one selected from the group of a state in which the conductance of the valve is reduced toward zero and a state in which it is maintained at zero. That is, in the pressure control of the present disclosure, the opening degree of the other valve, which is not selected, is set to a constant state.

Further, the recipe includes a specification for determining in advance one valve to be selected at an arbitrary first time according to the pressure setting value at a second time later than the first time. Based on the given recipe, the main controller 70 preselects one valve for pressure control while processing the substrates.

Further, the recipe includes, for each step included in the substrate processing, a specification for executing any one selected from the group of execution of a specific opening degree, execution of automatic control based on a specific pressure setting value, and execution of automatic control based on a specific pressure change rate for each of the first valve 58A and the second valve 58B.

The specific opening degree includes any one selected from the group of fully closed, fully open, and any opening degree other than fully closed and fully open. Further, the execution of automatic control by the specific pressure setting value and the execution of automatic control by the specific pressure change rate are specified by one valve for one step.

The pressure control device selects the first valve 58A when the future pressure setting value at a time, which arrives after the current time, is equal to or smaller than a predetermined first pressure. Further, the pressure control device selects the second valve 58B when the future pressure setting value is equal to or larger than the predetermined first pressure. Further, when the future pressure setting value is equal to or larger than a second pressure higher than the first pressure, the pressure control device allows the exhaust device 60 to operate at reduced power, that is, to reduce the gas flow rate to be exhausted, at a time corresponding to the future pressure setting value.

### <Substrate Processing Method>

Next, an example of processing a substrate will be described. In this embodiment, as an example of a process of manufacturing a semiconductor device, a film-forming process in which a first gas, which is a raw material gas as a source, and a second gas, which is a reaction gas as a reactant, are alternately supplied into the process container 20 is described.

For example, a Si- and halogen-containing gas can be used as the raw material gas. Halogen includes chlorine (Cl), fluorine (F), bromine (Br), iodine (I), and the like. It is desirable that the Si- and halogen-containing gas contains halogen in the form of a chemical bond between Si and halogen. The Si- and halogen-containing gas may further contain C, and in such a case, it is desirable to contain C in the form of a Si-C bond. For example, a silane-based gas containing Si, Cl, and an alkylene group and having a Si-C bond, that is, an alkylenechlorosilane-based gas, can be used as the Si- and halogen-containing gas. Here, the alkylene group includes a methylene group, an ethylene group, a propylene group, a butylene group, and the like. Further, for example, a silane-based gas containing Si, Cl, and an alkyl group and having a Si-C bond, that is, an alkylchlorosilane-based gas, can be used as the Si- and halogen-containing gas. It is desirable that the alkylenechlorosilane-based gas and the alkylchlorosilane-based gas contain Cl in the form of a Si-Cl bond and C in the form of a Si-C bond.

Examples of the Si- and halogen-containing gas may include alkylenechlorosilane-based gases such as a bis(trichlorosilyl)methane ((SiCl₃)₂CH₂, abbreviation: BTCSM) gas and a 1,2-bis(trichlorosilyl)ethane ((SiCl₃)₂C₂H₄, abbreviation: BTCSE) gas, alkylchlorosilane-based gases such as a 1,1,2,2-tetrachloro-1,2-dimethyldisilane ((CH₃)₂Si₂Cl₄, abbreviation: TCDMDS) gas and a 1,2-dichloro-1,1,2,2-tetramethyldisilane ((CH₃)₄Si₂Cl₂, abbreviation: DCTMDS) gas, gases containing a cyclic structure composed of Si and C, and halogen, such as a 1,1,3,3-tetrachloro-1,3-disilacyclobutane (C₂H₄Cl₄Si₂, abbreviation: TCDSCB) gas, and the like. Examples of the Si- and halogen-containing gas may also include inorganic chlorosilane-based gases such as a tetrachlorosilane (SiCl₄, abbreviation: STC) gas, a hexachlorodisilane (Si₂Cl₆, abbreviation: HCDS) gas, and an octachlorotrisilane (Si₃Cl₈, abbreviation: OCTS) gas, and the like.

Further, as the raw material gas, aminosilane-based gases such as a tetrakis(dimethylamino)silane (Si[N(CH₃)₂]₄, abbreviation: 4DMAS) gas, a tris(dimethylamino)silane (Si[N(CH₃)₂]₃H, abbreviation: 3DMAS) gas, a bis(diethylamino)silane (Si[N(C₂H₅)₂]₂H₂, abbreviation: BDEAS) gas, a bis(tert-butylamino)silane (SiH₂)[NH(C₄H₉)]₂, abbreviation: BTBAS) gas, and a (diisopropylamino)silane (SiH₃[N(C₃H₇)₂], abbreviation: DIPAS) gas may also be used instead of the Si- and halogen-containing gas.

For example, a Si-free gas, an oxidizing gas, or a reducing gas such as H₂ can be used as the reaction gas. An O- and H-containing gas can be used when forming an oxide-based film. For example, an O-containing gas including an O-H bond, such as water vapor (H₂O gas) or a hydrogen peroxide (HzOz) gas can be used as the O- and H-containing gas. In addition, an O-containing gas that does not include an O-H bond, such as hydrogen (H₂) gas+oxygen (O₂) gas or H₂ gas+ozone (O₃) gas, can also be used as the O- and H- containing gas. In the present disclosure, the description of two gases such as " H₂ gas+O₂ gas" together means a mixture of H₂ gas and O₂ gas. When a mixed gas is supplied, two gases may be mixed (i.e., pre-mixed) in a supply pipe and then supplied into the process chamber 201, or the two gases may be supplied separately from different supply pipes into the process chamber 201 and then mixed (i.e., post-mixed) in the process chamber 201.

As the reaction gas, a N- and H-containing gas can be used when forming a nitride-based film. Example of the N- and H-containing gas may include N- and H-containing gases including a N-H bond, such as an ammonia (NH₃) gas, a hydrazine (N₂H₄) gas, a diazene (N₂H₂) gas, and an N₃H₈ gas. When forming a nitride-based film, an oxidizing agent, oxidation, and oxidation reaction may be replaced with a nitriding agent, nitridation, and nitridation reaction, respectively.

In this embodiment, a Si source gas, such as disilane, as an example of the source, and a nitrogen-containing gas as an example of the reactant are used to form a silicon film (Si₃N₄ film, hereinafter also referred to as a SiN film) on a substrate 30.

The film-forming process includes supplying the first gas, which is the raw material gas, to the substrate 30 in the process container 20, and supplying the second gas, which is the reaction gas, to the substrate 30 in the process container 20. A cycle that includes non-simultaneously performing supplying the first gas and supplying the second gas is performed one or more predetermined times as a cycle process. The SiN film is formed on the substrate 30 by the cycle process.

Further, in this embodiment, a cleaning gas is supplied to the substrate 30 in the process container 20 during the cycle process. For example, HF, NO, or the like can be used as the cleaning gas. The cleaning gas corresponds to a third gas of the present disclosure. In this embodiment, a case where the third gas is the cleaning gas such as HF or NO is illustrated, but the present disclosure is not limited thereto, and the third gas can be changed as appropriate, for example, a nitriding gas such as NH₃.

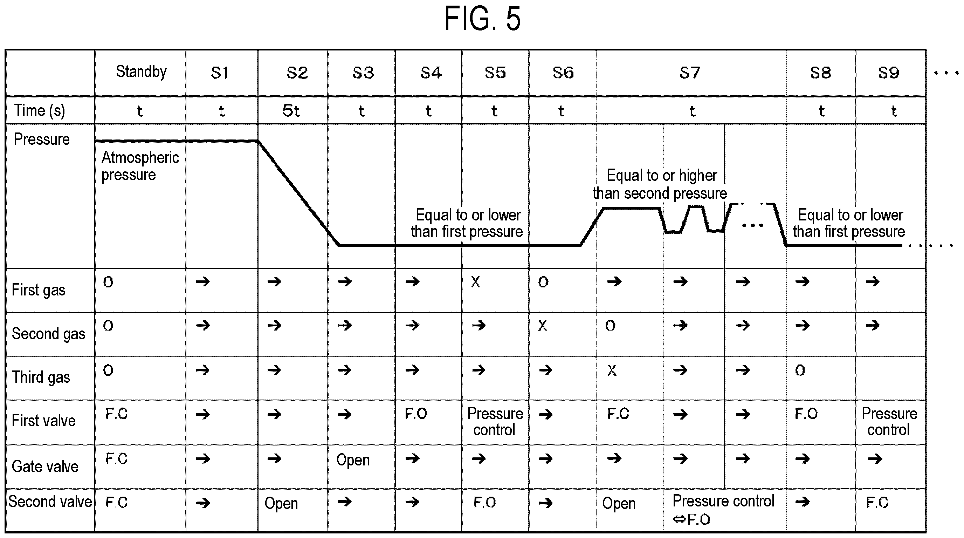

The method of processing the substrate according to this embodiment will be specifically described below with reference to FIG. 5. A symbol "→" shown in each step in FIG. 5 means that the same process as the immediately previous process shown on the left side is performed. Further, a symbol "O" in the processing of the first gas to the third gas in FIG. 5 means processing without a flowing gas, and a symbol "X" means processing with a flowing gas. Further, "F.C. " in the processing of the first valve, the gate valve, and the second valve in FIG. 5 means that the valves is fully closed, and "F.O. " means that the valves are fully opened.

First, as indicated by a position of a standby state in FIG. 5, the internal pressure of the process container 20 is set to the atmospheric pressure (approximately 1.023×10⁵ Pa, approximately 760 torr, 1 atmospheric pressure) in advance. In the standby state, none of the first gas, the second gas, and the third gas are supplied. Further, the first valve, all of the gate valve, and the second valve are fully closed.

Next, in step S1 in FIG. 5, the substrate 30 is loaded into the boat 26, and the boat 26 is carried into the process container 20. Next, in step S2 in FIG. 5, the second valve is opened to lower the internal pressure of the process container 20. Further, the internal temperature of the process container 20 is adjusted to a predetermined temperature. The time spent in the processing of step S2 is about five times of the processing time spent in the other steps.

Next, in step S3 in FIG. 5, the gate valve is opened. In step S3, the internal pressure of the process container 20 reaches a low-pressure region equal to or lower than the first pressure. In this embodiment, the first pressure is set to approximately 1.333×10³ Pa (approximately 10torr). Next, in step S4 in FIG. 5, the first valve is fully opened. The process container 20 is evacuated by a series of processing of steps S2 to S4.

### (First Gas Introduction Step)

Next, in step S5 in FIG. 5, the first gas is introduced into the process container 20. Here, in this embodiment, a first recipe is given to the pressure control device. According to the first recipe, based on a pressure control pattern in the low-pressure control region A2 created using the monotonically increasing curve in FIG. 4, the main controller selects the first valve as an opening degree adjustment valve through the first controller.

Specifically, the pressure control device selects the second valve because the future pressure setting value in steps S5 and S6 is equal to or smaller than the first pressure. In steps S5 and S6, the first recipe includes a specification for automatically controlling the opening degree of the first valve 58A so as to approach the future pressure setting value and fully closing the opening degree of the second valve. In the present disclosure, the specification of the first valve according to the first recipe is not limited thereto, and may be automatic control based on a specific opening degree and a specific pressure change rate.

Further, according to the first recipe, the main controller forces the second controller to fully close the second valve that is not selected. Further, the first recipe describes that the pressure control device does not change the first valve selected for pressure control to the second valve during steps S5 and S6.

According to the first recipe, the first gas is introduced into the process container 20 from the gas supply device 80, and the internal pressure of the process container 20 during the introduction of the first gas is controlled by adjusting the opening degree of the first valve that is selected. Further, when introducing the first gas, a N₂ gas or the like as a carrier gas may be mixed with the first gas.

Further, the first recipe of this embodiment includes a specification for determining in advance one valve to be selected at the start time of step S5 in the main controller of the pressure control device according to the pressure setting value at the start time of step S7 later than the start time of step S5. Therefore, during processing of the substrate in step S5 and the subsequent step S6, one valve for pressure control in step S7 is preselected prior to the start of step S7.

### (Second Gas Introduction Step)

Next, in step S6 in FIG. 5, the introduction of the first gas from the gas supply device 80 into the process container 20 is stopped. The exhaust device 60 vacuum-exhausts the process container 20 to remove the first gas of the remaining raw material gas from the process container 20. The effect of removing the residual raw material gas may be further enhanced by supplying an inert gas, for example, a N₂ gas used as a carrier gas, into the process container 20.

Further, the second gas, which is the reaction gas, is introduced from the gas supply device 80 into the process container 20 while the second valve remains in the fully closed state. When introducing the second gas, a N₂ gas or the like as a carrier gas may be mixed with the second gas. While introducing the second gas into the process container 20, the gas is exhausted from the first exhaust line 52 by the exhaust device 60. By supplying the reaction gas, the Si-containing film on a base film of the substrate 30 reacts with a nitrogen-containing gas to form a SiN film on the substrate 30. Further, the internal pressure of the process container 20 rises by being controlled by the first valve.

### (Cleaning Step)

After the SiN film is formed, in step S7 in FIG. 5, the interior of the process container 20 is vacuum-exhausted by the exhaust device 60 to remove the second gas, which is the reaction gas remaining after contributing to the film formation, from the interior of the process container 20. As in the case of step S6, the effect of removing the residual raw material gas may be further enhanced by supplying a N₂ gas to the process container 20.

Next, in this embodiment, a cleaning process is performed in a state where the internal pressure of the process container 20 is equal to or higher than the second pressure. The second pressure is approximately 13,332 Pa (100 torr).

Here, in this embodiment, a second recipe is given to the pressure control device. According to the second recipe, based on a pressure control pattern in the high-pressure control region A1 created using the monotonically increasing curve in FIG. 4, the main controller selects the second valve as an opening degree adjustment valve through the second controller.

Specifically, the pressure control device selects the second valve because the future pressure setting value in step S7 is equal to or larger than the first pressure which is the pressure setting value in steps S5 and S6. Further, the pressure control device allows the exhaust device to operate at reduced power at a time corresponding to the future pressure setting value because the future pressure setting value is equal to or larger than the second pressure which is higher than the first pressure.

Further, the second recipe includes a specification for fully closing the opening degree of the first valve 58A and automatically controlling the opening degree of the second valve 58B so as to approach the future pressure setting value. In the present disclosure, the specification of the second valve according to the second recipe is not limited thereto, and may be automatic control based on a specific opening degree and a specific pressure change rate. Further, the main controller forces the first controller to fully close the first valve that is not selected.

Further, the second recipe describes that the pressure control device does not change the second valve selected for pressure control to the first valve during steps S7 and S8.

According to the second recipe, the third gas is introduced from the gas supply device 80 into the process container 20, and the internal pressure of the process container 20 during the introduction of the third gas is controlled by adjusting the opening degree of the second valve that is selected. The opening degree of the second valve is repeatedly adjusted a plurality of times between a value equal to or greater than zero, which is not fully closed, and a fully open state, so as to follow the pressure setting value that changes with time.

Further, the second recipe includes a specification for determining in advance one valve to be selected at the start time of step S7 in the main controller of the pressure control device according to the pressure setting value at the start time of step S9 later than the start time of step S7. Based on the second recipe, during processing of the substrate in steps S7 and S8, one valve for pressure control in step S9 is preselected prior to the start of step S9.

Next, in step S8 in FIG. 5, the process container 20 is vacuum-exhausted in the same manner as in step S4. Next, in step S9 in FIG. 5, the first gas, which is the raw material gas, is introduced in the same manner as in step S5. Although not shown, in a step following step S9, the second gas, which is the reaction gas, is introduced in the same manner as in step S6.

That is, one cycle including the process of step S5 and the process of step S6 is repeated one or more times, whereby a SiN film having a predetermined thickness can be formed on the substrate 30. In the present disclosure, the cleaning process of step S7 may be appropriately combined in one cycle including the process of step S5 and the process of step S6, or a series of processes of steps S5 to S7 may be performed a plurality of times cyclically.

After the film-forming process is completed, the internal pressure of the process container 20 is returned to the atmospheric pressure. Specifically, an inert gas such as a N₂ gas is supplied from the gas supply device 80 into the process container 20 for exhaust. Due to the exhaust, the interior of the process container 20 is purged with the inert gas, and a gas and the like remaining in the process container 20 are removed from the interior of the process container 20.

Then, the internal atmosphere of the process container 20 is substituted with the inert gas, and the internal pressure of the process container 20 is returned to the atmospheric pressure. Then, when the substrate 30 is unloaded from the process container 20, the substrate processing according to this embodiment is completed. A semiconductor device can be manufactured by subjecting the unloaded substrate to a predetermined process.

### (Operation and Effects)

In the substrate processing apparatus 100 according to this embodiment, one valve among the first valve 58A and the second valve 58B is selected according to the pressure setting value in the process container 20 which is set at each time in order to process the substrate 30. Then, the opening degree of the other valve, which is not selected, is set to a constant state, and the opening degree of the selected one valve is adjusted while being maintained at a value greater than zero. The adjustment allows a pressure detection value detected by the pressure detector 62 to approach the pressure setting value.

Therefore, during pressure control, it is possible to suppress occurrence of a state in which the first valve 58A and the second valve 58B are switched therebetween irrespective of the control operation. As a result, it is possible to prevent interruption of the pressure control caused by the switching between the first valve 58A and the second valve 58B.

Further, in this embodiment, the first valve 58A is configured as a butterfly valve, and the second valve 58B is configured as a poppet valve. Further, the substrate processing apparatus 100 includes the gate valve 56 installed in series with the first valve 58A. Further, the main controller 70 of the pressure control device controls to open the gate valve 56 before starting the process of step S5 in which the first valve 58A is selected. Therefore, the first gas can be smoothly introduced into the process container 20 via the first valve 58A and the gate valve 56.

Further, in this embodiment, the opening degree of the first valve 58A selected in step S5 is continuously adjusted until the start time of step S7 arrives. That is, it is possible to adjust the opening degree of the first valve 58A used in the low-pressure control region A2 until the time corresponding to the future pressure setting value in the high-pressure control region A1 arrives later. Therefore, it is possible to further enhance the accuracy of pressure control in the low-pressure control area A2.

Further, the opening degree of the second valve 58B selected in step S7 is continuously adjusted until the start time of step S9 arrives. That is, it is possible to adjust the opening degree of the second valve 58B used in the high-pressure control area A1 until the time corresponding to the future pressure setting value in the low-pressure control area A2 arrives later. Therefore, it is possible to further enhance the accuracy of pressure control in the high-pressure control region A1.

In this embodiment, a period in which the opening degree of the selected valve is adjusted is illustrated only until the time corresponding to the future pressure setting value arrives, but the present disclosure is not limited thereto. In the present disclosure, the adjustment may be made only until the actual pressure detected by the pressure detector 62 becomes the future pressure setting value. Alternatively, the adjustment may be made both until the time corresponding to the future pressure setting value arrives and until the actual pressure detected by the pressure detector 62 becomes the future pressure setting value.

Further, in this embodiment, the first recipe for determining in advance one valve to be selected at the first time, which is the start time of step S5, according to the pressure setting value at the second time, which is the start time of step S7 later than the first time, is given to the main controller 70 of the pressure control device. Further, based on the given recipe, one valve is preselected for pressure control while processing the substrate 30 in steps S5 and S6. Therefore, when the second time arrives, it is possible to smoothly select an opening degree adjustment valve, thereby preventing a delay in the pressure control operation in step S7.

Further, the second recipe for determining in advance one valve to be selected at the second time, which is the start time of step S7, according to the pressure setting value at a third time, which is the start time of step S9 later than the second time, is given to the main controller 70 of the pressure control device. Further, during processing of the substrate 30 in steps S7 and S8, based on the given recipe, one valve is preselected for pressure control. Therefore, when the third time arrives, it is possible to smoothly select an opening degree adjustment valve, thereby preventing a delay in the pressure control operation in step S9.

In this embodiment, a case where the start time of step S5 is set as the first time, the start time of step S7 is set as the second time, and the start time of step S9 is set as the third time is illustrated, but the present disclosure is not limited thereto. In the present disclosure, the first time, which is the starting point, can be set at any time. That is, even the start time of step S7 or the start time of step S9 can be set as the "first time".

Further, in this embodiment, in step S5 or step S7, one of the first controller 72A and the second controller 72B corresponds to the other valve, which is not selected, and is forced to set the other valve to the fully closed state. Here, in this embodiment, the first monotonically increasing curve L1 and the second monotonically increasing curve L2 used for pressure control are set in a state in which one of the two valves is fully closed, that is, the conductance of the one valve is zero. Therefore, by fully closing the other valve that is not selected, the pressure control based on the first monotonically increasing curve L1 and the second monotonically increasing curve L2 can be performed more accurately.

Further, in this embodiment, the recipe includes, for each step included in the substrate processing, a specification for executing any one selected from the group of execution of a specific opening degree, execution of automatic control based on a specific pressure setting value, and execution of automatic control based on a specific pressure change rate for each of the first valve 58A and the second valve 58B. Therefore, for example, the pressure can be controlled with higher accuracy than pressure control specifying only a specific opening degree, for the first valve 58A and the second valve 58B.

Further, in this embodiment, the first valve 58A has a maximum conductance greater than the maximum conductance of the second valve 58B. Further, in step S5, the pressure control device selects the first valve 58A when the future pressure setting value is lower than the first pressure. This is advantageous in pressure control for the pressure setting value lower than the first pressure.

Further, in this embodiment, in step S7, the pressure control device selects the second valve 58B when the future pressure setting value is equal to or larger than the first pressure. Therefore, it is advantageous in pressure control for the pressure setting value equal to or larger than the first pressure. Further, the pressure control device allows the exhaust device to operate at reduced power at a time corresponding to the future pressure setting value at or above the second pressure higher than the first pressure. Therefore, it is possible to perform pressure control with a valve having excellent controllability that is most suitable in terms of pressure and exhaust speed each time control. As a result, it is possible to enhance the responsiveness of the actual pressure to the target pressure setting value.

Further, in this embodiment, once the main controller 70 of the pressure control device selects one corresponding valve for each step of substrate processing described as a recipe, it does not change the selected one valve to a different valve in the corresponding step. Therefore, it is possible to reduce a burden accompanying a work of frequently switching between opening degree adjustment valves in a step corresponding to each recipe and to prevent the wear and tear of the device.

Further, in this embodiment, the main controller 70 of the pressure control device selects one valve according to the first monotonically increasing curve L1 and the second monotonically increasing curve L2 which are the conditions using the combination of the gas flow rate and the pressure setting value by the gas supply device. Therefore, it is possible to control the pressure with higher accuracy than when the combination of the gas flow rate and the future pressure setting value is not used.

Further, in this embodiment, the first monotonically increasing curve L1 is determined based on the exhaust characteristics when the first valve 58A is fixed to a minimum value slightly larger than zero corresponding to the fully closed and the second valve 58B is fixed to the fully open. Further, the second monotonically increasing curve L2 is determined based on the exhaust characteristics when the first valve 58A is fixed to the fully closed and the second valve 58B is fixed to the fully open. Then, in the graph of FIG. 4, when the coordinate of the combination of the gas flow rate and the pressure setting value is located below the second monotonically increasing curve L2, the first valve 58A is selected as the opening degree adjustment valve.

In the low-pressure control region A2 below the second monotonically increasing curve L2, it is possible to achieve the target pressure setting value by adjusting the opening degree of the first valve 58A having a larger maximum conductance than that of the second valve 58B. Therefore, when the coordinate of the combination of the gas flow rate and the pressure setting value is located below the second monotonically increasing curve L2, it is possible to control the pressure with high accuracy.

Further, the pressure control device that performs the pressure control described in the substrate processing apparatus 100 can be implemented as a pressure control device according to this embodiment, which is different from the substrate processing apparatus 100. With the pressure control device according to this embodiment, like the substrate processing apparatus 100, it is possible to prevent pressure control from being interrupted due to switching between the first valve 58A and the second valve 58B.

Further, a substrate processing program according to this embodiment, which performs the pressure control described in the substrate processing apparatus 100, can be created. With the substrate processing program according to this embodiment, like the substrate processing apparatus 100, it is possible to prevent pressure control from being interrupted due to switching between the first valve 58A and the second valve 58B.

Further, a method of manufacturing a semiconductor device according to this embodiment, including a method of processing the substrate using the substrate processing apparatus 100, can be configured. With the method of manufacturing a semiconductor device according to this embodiment, it is possible to prevent the pressure control from being interrupted due to the switching between the first valve 58A and the second valve 58B, so that the semiconductor device can be manufactured with improved quality.

### <Other Aspects of the Present Disclosure>

While the present disclosure has been described through the aspects of the disclosed embodiments above, the descriptions and drawings, which form parts of this disclosure, should not be understood as limiting the present disclosure. The present disclosure is not limited to the aspects described above, but may be modified in various ways without departing from the gist of the present disclosure.

### (First Modification)

In the present embodiment, a case where a valve to be selected is uniquely determined depending on whether the location of the coordinate of the combination of the gas flow rate and the pressure setting value is the high-pressure control region A1 above the first monotonically increasing curve L1 or the low-pressure control region A2 below the second monotonically increasing curve L2 is illustrated. However, the present disclosure is not limited thereto.

For example, in the present disclosure, in a future step included within a predetermined time from now or a step at least partially included in a predetermined time, one valve may be selected according to a rate of a case that the coordinate of the combination of the gas flow rate and the pressure setting value is located below the second monotonically increasing curve L2 and a rate of a case that the coordinate of the combination of the gas flow rate and the pressure setting value is located above the first monotonically increasing curve L1.

Specifically, the rate of the case that the coordinate of the combination of the gas flow rate and the pressure setting value is located below the second monotonically increasing curve L2 and the rate of the case that the coordinate of the combination of the gas flow rate and the pressure setting value is located above the first monotonically increasing curve L1 are calculated respectively. Then, one valve for pressure control, which is set for a region with the larger calculated rate, can be selected as the opening degree adjustment valve. That is, if the selection is made only based on the monotonically increasing curve, although a work of switching between the first valve 58A and the second valve 58B occurs relatively frequently, the calculated rate is used so that only the one selected valve continues to be used for pressure control within a specified process.

For example, in this embodiment, when the coordinate of the combination of the gas flow rate and the pressure setting value is located in the low-pressure control region A2 below the second monotonically increasing curve L2, the pressure is controlled by changing the opening degree of the first valve 58A while the second valve 58B is fully opened. In the low-pressure control region A2 below the second monotonically increasing curve L2, a relatively large change in the gas flow rate may be required to change from the current pressure to the target pressure setting value. Therefore, for example, depending on the specification of the first valve 58A, there is a concern that the pressure setting value cannot be achieved.

On the other hand, in this embodiment, when the coordinate of the combination of the gas flow rate and the pressure setting value is located in the high-pressure control region A1 above the first monotonically increasing curve L1, a range in which the gas flow rate supplied to the process container 20 is changed can be smaller than that in the low-pressure control region A2. However, if a work of switching between the two valves frequently occurs as the pressure setting value changes with time, a burden accompanying the work increases and there is concern about the wear and tear of the device.

For this reason, in the present disclosure, even if a pressure drop is caused by fixing a valve selected for opening degree adjustment to one of the two valves for a predetermined time, as long as the caused pressure drop is within an acceptable range of the processing process, it is able to continuously use only the valve which is selected. By fixing the opening degree adjustment valve, it is possible to reduce the burden accompanying the work of frequently switching between valves and to prevent the wear and tear of the device.

### (Second Modification)

Furthermore, in the present disclosure, the rate of the case that the coordinate of the combination of the gas flow rate and the pressure setting value is located above the first monotonically increasing curve L1 may be lighter weighted than the rate of the case that the coordinate is located below the second monotonically increasing curve L2. Due to the weighting, when the rate of the case that the coordinate is located above the first monotonically increasing curve L1 becomes lower than the rate of the case that the coordinate is located below the second monotonically increasing curve L2, the first valve 58A is selected rather than the second valve 58B.

By lighter weighting the rate of the case that the coordinate is located above the first monotonically increasing curve L1, it is possible to reduce the burden accompanying the work of frequently switching between valves and to prevent the wear and tear of the device. The method of lighter weighting the rate of the case that the coordinate is located above the first monotonically increasing curve L1 is advantageous when the priority of pressure control by the second valve 58B is low. As a case where the priority of pressure control by the second valve 58B is low, for example, there may be a case where it is possible to achieve the entire target pressure setting value range only by adjusting the opening degree of the first valve 58A.

### (Third Modification)

Further, in the present disclosure, a location rate of the coordinate of the combination may be weighted by a distance between the location of the coordinate in the graph of FIG. 4 and the first monotonically increasing curve L1 or the second monotonically increasing curve L2. Here, the "distance" means a length between the coordinate and the first monotonically increasing curve L1 or the second monotonically increasing curve L2 that is closest to the location of the coordinate of the combination.

Specifically, for example, when a distance between the location of a certain coordinate and the first monotonically increasing curve L1 is shorter than a distance between the location of the coordinate and the second monotonically increasing curve L2, the priority of selection of the first valve 58A corresponding to the low-pressure control region A2 below the second monotonically increasing curve L2 increases. That is, the rate of the case that the coordinate is located above the first monotonically increasing curve L1 is lightly weighted so as to decrease the priority of selection of the second valve 58B. As a result of the weighting, it is possible to reduce the burden accompanying the work of frequently switching between valves and to prevent the wear and tear on the device.

### (Fourth Modification)

Further, in the present disclosure, the main controller 70 of the pressure control device may be configured to select the first valve 58A when the sum of time of states in which the coordinate of the combination of the gas flow rate and the pressure setting value in a step included within a predetermined time from now or a step at least partially included in a predetermined time is located above the first monotonically increasing curve L1 is equal to or less than a predetermined time. By using the sum of time of states in which the coordinate is located above the first monotonically increasing curve L1, when the priority of pressure control by the second valve 58B is low, it is possible to reduce the burden accompanying the work of frequently switching between and to prevent the wear and tear of the device.

### (Fifth Modification)

Further, for example, in this embodiment, in steps S5 and S6, the first valve 58A is used to allow both the first gas and the second gas to flow at the same flow rate, so that the first gas and the second gas are exposed to the substrate. Then, the process of substrate processing for controlling the pressure detection value to approach the target value is illustrated. However, the present disclosure is not limited to the substrate processing process of allowing both the first gas and the second gas to flow at the same flow rate, and may be applied to various other aspects or processes.

For example, in another aspect, the recipe may include a first exposure step of allowing the first gas to flow at a first flow rate to control the pressure detection value to approach the first target value, and a second exposure step of allowing the second gas to flow at a second flow rate to control the pressure detection value to approach a second target value higher than the first target value. Further, according to the recipe, the pressure control device may select the first valve 58A for the first exposure step and the second valve 58B for the second exposure step.

In the another aspect, according to the recipe, when the pressure control device selects the first valve 58A for the first exposure step and the second valve 58B for the second exposure step, as in the present embodiment, it is possible to prevent interruption of pressure control due to switching between a plurality of valves during pressure control.

In still another aspect, the first exposure step may use a film-forming gas as the first gas, and the second exposure step may use a cleaning gas as the second gas.

According to the still another aspect, when two kinds of gases, that is, the film-forming gas and the cleaning gas, are used, it is possible to prevent interruption of pressure control due to switching between a plurality of valves during pressure control.

When the substrate processing apparatus 100 is used in each of another aspect and the still another aspect described above, each process can be performed according to the same processing procedures and process conditions as in the aspect according to this embodiment. Further, in each of another aspect and the still another aspect, the same effects as in the aspect according to this embodiment can be obtained.

Further, the present disclosure may be configured by partially combining the configurations included in the above-disclosed multiple embodiments, modifications, and aspects. In the present disclosure configured by the combination, the processing procedures and process conditions to be executed may be configured in the same manner as the processing procedures and process conditions described in the aspect according to this embodiment, for example. The present disclosure covers various embodiments and the like not described above, and the technical scope of the present disclosure is defined only by the disclosure specifying matters of the claims that are valid from the above description.

### <Supplementary Notes>

The following aspects are conceptualized from the present disclosure.

Aspect 1 is a substrate processing apparatus including:
a process container in which a substrate is processed;
an exhaust path that is connected between the process container and an exhaust device and configured to branch into a first exhaust line and a second exhaust line between the process container and the exhaust device;
a first valve that is installed in the first exhaust line and configured to be capable of continuously adjusting an opening degree of the first valve;
a second valve that is installed in the second exhaust line and is configured to be capable of continuously adjusting an opening degree of the second valve;
a pressure detector configured to detect a pressure in the process container; and
a pressure control device configured to be capable of: selecting one valve among the first valve and the second valve according to a pressure setting value in the process container, which is set at each time for processing the substrate, such that a pressure detection value detected by the pressure detector to the pressure setting value; setting an opening degree of an other valve, which is not selected among the first valve and the second valve, to a constant state; and adjusting an opening degree of the selected one valve while maintaining the opening degree of the selected one valve at a value greater than zero.

Aspect 2 is the substrate processing apparatus of Aspect 1, wherein a recipe as a program including a substrate processing procedure is given to the pressure control device, and the pressure control device includes a computer that executes substrate processing based on the recipe,
wherein the recipe for predetermining the one valve selected at an arbitrary first time according to the pressure setting value at a second time, which arrives after the first time, is given to the pressure control device, and
wherein while processing the substrate, the one valve is selected based on the recipe.

Aspect 3 is the substrate processing apparatus of Aspect 2, further including; a gas supply device that supplies a first gas and a second gas at flow rates controlled according to the recipe to the process container,
wherein the recipe includes a first exposure step of allowing the first gas to flow at a first flow rate to control the pressure detection value to approach a first target value, and a second exposure step of allowing the second gas to flow at a second flow rate to control the pressure detection value to approach a second target value higher than the first target value, and
wherein the pressure control device is configured to be capable of selecting the first valve in the first exposure step and selecting the second valve in the second exposure step.

Aspect 4 is the substrate processing apparatus of Aspect 3, wherein a film-forming gas is used as the first gas in the first exposure step, and a cleaning gas is used as the second gas in the second exposure step.

In addition, all literatures, patent applications, and technical standards mentioned in the present disclosure are incorporated herein by reference to the same extent as if individual literatures, patent applications, and technical standards were specifically and individually noted.

## Claims

1. A substrate processing apparatus comprising:
a process container in which a substrate is processed;
an exhaust path that is connected between the process container and an exhaust device and configured to branch into a first exhaust line and a second exhaust line between the process container and the exhaust device;
a first valve that is installed in the first exhaust line and configured to be capable of continuously adjusting an opening degree of the first valve;
a second valve that is installed in the second exhaust line and configured to be capable of continuously adjusting an opening degree of the second valve;
a pressure detector configured to detect a pressure in the process container; and
a pressure control device configured to be capable of: selecting one valve among the first valve and the second valve according to a pressure setting value in the process container, which is set at each time for processing the substrate, such that a pressure detection value detected by the pressure detector approaches the pressure setting value; setting an opening degree of an other valve, which is not selected among the first valve and the second valve, to a constant state; and adjusting an opening degree of the selected one valve while maintaining the opening degree of the selected one valve at a value greater than zero.

2. The substrate processing apparatus of Claim 1, wherein the pressure control device is configured to be capable of adjusting the opening degree of the selected one valve while maintaining the opening degree of the selected one valve at a value greater than zero during at least one selected from the group of a period until a specific time arrives from a current time and a period until the pressure detection value detected by the pressure detector becomes the pressure setting value of the specific time, while processing the substrate.

3. The substrate processing apparatus of Claim 1, wherein a recipe as a program including a substrate processing procedure is given to the pressure control device, and the pressure control device includes a computer that executes substrate processing based on the recipe,
wherein the recipe for predetermining the one valve, which is selected at an arbitrary first time according to the pressure setting value at a second time, which arrives after the first time, is given to the pressure control device, and
wherein the one valve is selected based on the recipe while processing the substrate.

4. The substrate processing apparatus of Claim 1, wherein the pressure control device is configured to be capable of setting and adjusting a conductance of the other valve, which is not selected among the first valve and the second valve, to a state in which the conductance of the other valve is reduced toward zero or a state in which the conductance of the other valve is maintained at zero during at least one selected from the group of a period until a specific time arrives from a current time and a period until the pressure detection value detected by the pressure detector becomes the pressure setting value of the specific time, while processing the substrate.

5. The substrate processing apparatus of Claim 4, wherein the pressure control device includes:
a first controller configured to be capable of automatically adjusting a conductance of the first valve based on the pressure detection value and the pressure setting value; and
a second controller configured to be capable of automatically adjusting the conductance of the second valve based on the pressure detection value and the pressure setting value, and
wherein a controller, which corresponds to the non-selected other valve among the first controller and the second controller, fully closes the other valve.

6. The substrate processing apparatus of Claim 3, wherein the recipe includes, for each step included in the substrate processing, a specification for executing any one selected from the group of an execution of a specific opening degree, an execution of automatic control by a specific pressure setting value, and an execution of automatic control by a specific pressure change rate, with respect to each of the first valve and the second valve,
wherein the specific opening degree includes any one selected from the group of fully closed, fully open, and any opening degree other than fully closed and fully open, and
wherein the execution of automatic control by the specific pressure setting value and the execution of automatic control by the specific pressure change rate are specified by one of the first valve and the second valve, for one step.

7. The substrate processing apparatus of Claim 1, wherein the process container further includes a gas supply device that supplies a gas at a controlled flow rate, and
wherein the pressure control device selects the one valve according to a condition using a combination of a gas flow rate by the gas supply device and the pressure setting value.

8. The substrate processing apparatus of Claim 1, wherein the first valve has a conductance greater than a maximum conductance of the second valve, and
wherein the pressure control device selects the first valve when the pressure setting value is smaller than a predetermined first pressure.

9. The substrate processing apparatus of Claim 1, wherein the first valve has a conductance greater than a maximum conductance of the second valve, and
wherein the pressure control device selects the second valve when the pressure setting value is equal to or larger than a predetermined first pressure, and allows the exhaust device to operate at reduced power at a time corresponding to the pressure setting value when the pressure setting value is equal to or larger than a second pressure that is higher than the first pressure.

10. The substrate processing apparatus of Claim 7, wherein the first valve has a conductance greater than a maximum conductance of the second valve, and
wherein the pressure control device selects the first valve when a coordinate of the combination of the gas flow rate and the pressure setting value is located below a predetermined monotonically increasing curve defined by a coordinate system with a horizontal axis as a gas flow rate and a vertical axis as a pressure.

11. The substrate processing apparatus of Claim 10, wherein the monotonically increasing curve is determined based on exhaust characteristics when the first valve is fully closed and the second valve is fully opened.

12. The substrate processing apparatus of Claim 7, wherein in a step included within a predetermined time from now or a step included at least partially in the predetermined time, the pressure control device selects the one valve according to a rate of a case that a coordinate of a combination of the gas flow rate and the pressure setting value is located below a predetermined monotonically increasing curve and a rate of a case that the coordinate is located above the monotonically increasing curve .

13. The substrate processing apparatus of Claim 1, wherein a recipe as a program including a substrate processing procedure is given to the pressure control device, and the pressure control device includes a computer that executes substrate processing based on the recipe,
wherein, when the corresponding one valve for each step of substrate processing described as the recipe is selected, the pressure control device does not change the selected one valve to a different valve in the corresponding step.

14. The substrate processing apparatus of Claim 12, wherein the rate of the case that the coordinate is located above the monotonically increasing curve is lighter weighted than the rate of the case that the coordinate is located below the monotonically increasing curve.

15. The substrate processing apparatus of Claim 12, wherein the rate is weighted by a distance between the coordinate and the monotonically increasing curve.

16. The substrate processing apparatus of Claim 12, wherein in a step included within a predetermined time from now or a step included at least partially in the predetermined time, the pressure control device selects the first valve when the time at which the coordinate of the combination of the gas flow rate and the pressure setting value is located above the monotonically increasing curve is equal to or less than a predetermined time.

17. The substrate processing apparatus of Claim 1, wherein the second exhaust line branches at a substantially right angle in the middle of the first exhaust line,
wherein the first valve is configured as a butterfly valve, and
wherein the second valve is configured as a poppet valve,
wherein the substrate processing apparatus further comprising a gate valve provided in series with the first valve, and
wherein the pressure control device controls the gate valve to be opened before the first valve initiates a selected step.

18. A method of manufacturing a semiconductor device in a substrate processing apparatus including:
a process container in which a substrate is processed,
an exhaust path that is connected between the process container and an exhaust device and configured to branch into a first exhaust line and a second exhaust line between the process container and the exhaust device,
a first valve that is installed in the first exhaust line and configured to be capable of continuously adjusting an opening degree of the first valve,
a second valve that is installed in the second exhaust line and configured to be capable of continuously adjusting an opening degree of the second valve, and
a pressure detector that detects a pressure in the process container,
the method comprising:
selecting one valve among the first valve and the second valve according to a pressure setting value in the process container, which is set at each time for processing the substrate, such that a pressure detection value detected by the pressure detector approaches the pressure setting value; and
setting the opening degree of an other valve, which is not selected among the first valve and the second valve, to a constant state, and adjusting the opening degree of the selected one valve while maintaining the opening degree of the selected one valve at a value greater than zero.

19. A pressure control device provided in a substrate processing apparatus including:
a process container in which a substrate is processed;
an exhaust path that is connected between the process container and an exhaust device and configured to branch into a first exhaust line and a second exhaust line between the process container and the exhaust device;
a first valve that is installed in the first exhaust line and configured to be capable of continuously an opening degree of the first valve;
a second valve that is installed in the second exhaust line and configured to be continuously adjusting an opening degree of the second valve; and
a pressure detector that detects a pressure in the process container,
the pressure control device comprising:
a main controller configured to be capable of selecting one valve among the first valve and the second valve according to a pressure setting value in the process container, which is set at each time for processing the substrate, such that a pressure detection value detected by the pressure detector approaches the pressure setting value for processing the substrate, setting the opening degree of an other valve, which is not selected among the first valve and the second valve, to a constant state, and adjusting the opening degree of the selected one valve while maintaining the opening degree of the selected one valve at a value greater than zero.

20. A substrate processing program that is executed in a substrate processing apparatus including:
a process container in which a substrate is processed,
an exhaust path that is connected between the process container and an exhaust device and configured to branch into a first exhaust line and a second exhaust line between the process container and the exhaust device,
a first valve that is installed in the first exhaust line and configured to be capable of continuously adjusting an opening degree of the first valve,
a second valve that is provided installed in the second exhaust line and configured to be capable of continuously adjusting an opening degree of the second valve, and
a pressure detector that detects the a pressure of in the process container,
the substrate processing program causing, by a computer, the substrate processing apparatus to perform a process comprising:
selecting one valve among the first valve and the second valve according to a pressure setting value in the process container, which is set at each time for processing the substrate, such that a pressure detection value detected by the pressure detector approaches the pressure setting value; and
setting the opening degree of an other valve, which is not selected among the first valve and the second valve, to a constant state, and adjusting the opening degree of the selected one valve while maintaining the opening degree of the selected one valve at a value greater than zero.
